# EUROPEAN PATENT APPLICATION

(11) **EP 4 207 545 A1**
(43) Date of publication of application: **05.07.2023**
(21) Application number: 22776027.9
(22) Date of filing: 21.03.2022
(51) Int. Cl.: H02J 7/00, G01R 19/165, G01R 31/36, H02M 1/08

(54) **BATTERY MANAGEMENT DEVICE AND BATTERY PACK COMPRISING SAME**

(30) Priority: 24.03.2021 KR 20210038127
(71) Applicant: LG Energy Solution, Ltd., Seoul 07335 (KR)
(72) Inventor: CHOI, Jang-Hyeok, Daejeon 34122 (KR); CHOI, Jae-Hong, Daejeon 34122 (KR)
(74) Representative: Hoffmann Eitle
(86) International application number: PCT/KR2022/003934
(87) International publication number: WO 2022/203326

(57) **Abstract**

A battery management apparatus according to an embodiment of the present disclosure includes a converter unit electrically connected to a first node between a battery and one end of a positive electrode relay connected in series to the battery and configured to convert a voltage of the battery into a predetermined voltage and output the predetermined voltage based on an operation mode; and a converter driving unit connected to the first node to receive the battery voltage from the battery and configured to control the operation mode of the converter unit based on the battery voltage to a shutdown mode in which the converter unit is inactivated or a wakeup mode in which the converter unit is activated.

## Description

### TECHNICAL FIELD

The present application claims priority to Korean Patent Application No. 10-2021-0038127 filed on March 24, 2021 in the Republic of Korea, the disclosures of which are incorporated herein by reference.

The present disclosure relates to a battery management apparatus and a battery pack including the same, and more particularly, to a battery management apparatus for preventing a battery from being overdischarged, and a battery pack including the same.

### BACKGROUND ART

Recently, as the demand for portable electronic products such as laptops, video cameras, mobile phones, and the like is rapidly increased and the development of electric vehicles, storage batteries for energy storage, robots, satellites, and the like is in earnest, high-performance batteries capable of repeatedly charging and discharging is actively studied.

Batteries currently commercialized include nickel cadmium batteries, nickel hydride batteries, nickel zinc batteries, and lithium batteries. Among them, the lithium batteries have almost no memory effect compared to nickel-based batteries, to freely charge and discharge, and have a very low high self-discharge rate and a high energy density. Thus, lithium batteries have attracted much attention.

In general, a battery is provided in a battery pack, and may supply power to a device such as a battery management system (BMS) provided in the battery pack through a DC-DC converter. In this case, since the power applied from the battery to the BMS or the like is always supplied, there is a problem that the battery voltage may be continuously consumed even when the connection between the battery pack and the load is cut off. That is, since the battery voltage is continuously consumed while the DC-DC converter is being driven, there is a problem that the battery may be overdischarged. Therefore, it is required to develop a technology that can increase the lifespan of the battery by controlling the driving of the DC-DC converter according to a voltage level of the battery to prevent the battery from being overdischarged.

### DISCLOSURE

### Technical Problem

The present disclosure is designed to solve the problems of the related art, and therefore the present disclosure is directed to providing a battery management apparatus for preventing a battery from being overdischarged by controlling an operation mode of a converter unit based on a battery voltage, and a battery pack including the same.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management apparatus according to an aspect of the present disclosure comprises: a converter unit electrically connected to a first node between a battery and one end of a positive electrode relay connected in series to the battery and configured to convert a voltage of the battery into a predetermined voltage and output the predetermined voltage based on an operation mode; and a converter driving unit connected to the first node to receive the battery voltage from the battery and configured to control the operation mode of the converter unit based on the battery voltage to a shutdown mode in which the converter unit is inactivated or a wakeup mode in which the converter unit is activated.

The converter driving unit may be configured to compare the battery voltage with a preset criterion voltage and control the operation mode of the converter unit based on the comparison result.

The converter driving unit may be configured to control the operation mode of the converter unit to the shutdown mode, when the battery voltage is less than the criterion voltage.

The converter driving unit may be configured to control the operation mode of the converter unit to the wakeup mode, when the battery voltage is equal to or greater than the criterion voltage.

The converter driving unit may be further connected to a second node at the other end of the positive electrode relay and configured to control the operation mode of the converter unit when an external voltage is input through the second node.

In the case where the operation mode of the converter unit is the shutdown mode, the converter driving unit may be configured to control the operation mode of the converter unit to the wakeup mode when the external voltage is input.

The converter driving unit may include a power module electrically connected to the first node and configured to receive the battery voltage from the battery, convert the received battery voltage and output the converted battery voltage; and a driving module configured to receive a power applied from the power module, electrically connected to the first node, the second node and the converter unit, and configured to control the operation mode of the converter unit based on the battery voltage received through the first node, the external voltage received through the second node, and the criterion voltage.

A battery management apparatus according to another aspect of the present disclosure may further comprise a control unit configured to control an operation state thereof to an inactive mode or an active mode based on whether a power is applied according to the operation mode of the converter unit and control an operation state of the positive electrode relay according to the controlled operation state.

The control unit may be configured to control the operation state to the active mode by receiving a power from the converter unit, when the operation mode of the converter unit is controlled to the wakeup mode.

The control unit may be configured to control the operation state to the inactive mode by not receiving a power from the converter unit, when the operation mode of the converter unit is controlled to the shutdown mode.

The control unit may be configured to control the operation state of the positive electrode relay to a turn-off state, when the operation state is controlled from the active mode to the inactive mode.

The control unit may be configured to control the operation state of the positive electrode relay to a turn-on state, when the operation state is controlled from the inactive mode to the active mode.

A battery pack according to another aspect of the present disclosure may comprise the battery management apparatus according to one aspect of the present disclosure.

### Advantageous Effects

According to one aspect of the present disclosure, by controlling the operation mode of the converter unit to a shutdown mode when the battery voltage is equal to or less than a certain level, it is possible to prevent the battery from being overdischarged. Accordingly, the battery voltage is prevented from being unnecessarily consumed, thereby increasing the lifespan of the battery.

The effects of the present disclosure are not limited to the effects mentioned above, and other effects not mentioned will be clearly understood by those skilled in the art from the following detailed description and the appended claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a battery management apparatus according to an embodiment of the present disclosure.
FIG. 2 is a diagram schematically showing an exemplary configuration of a battery pack including the battery management apparatus according to an embodiment of the present disclosure.
FIG. 3 is a diagram showing the battery pack of FIG. 2 in more detail.
FIG. 4 is a diagram schematically showing another exemplary configuration of the battery pack including the battery management apparatus according to an embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

In addition, in describing the present disclosure, if it is determined that detailed description of a related configuration or function may obscure the gist of the present disclosure, the detailed description will be omitted.

Terms including ordinal numbers, such as first and second, are used for the purpose of distinguishing any one of various components from the others, and are not used to limit the components by the terms.

Throughout the specification, when a part "includes" a certain component, it means that the part may further include other components, without excluding other components, unless otherwise stated. In addition, throughout the specification, when a part is "connected" to another part, this includes not only the case where these parts are "directly connected" but also the case where these parts are "indirectly connected" with another element being interposed therebetween.

Hereinafter, preferred embodiments of the present disclosure will be described in detail with reference to the accompanying drawings.

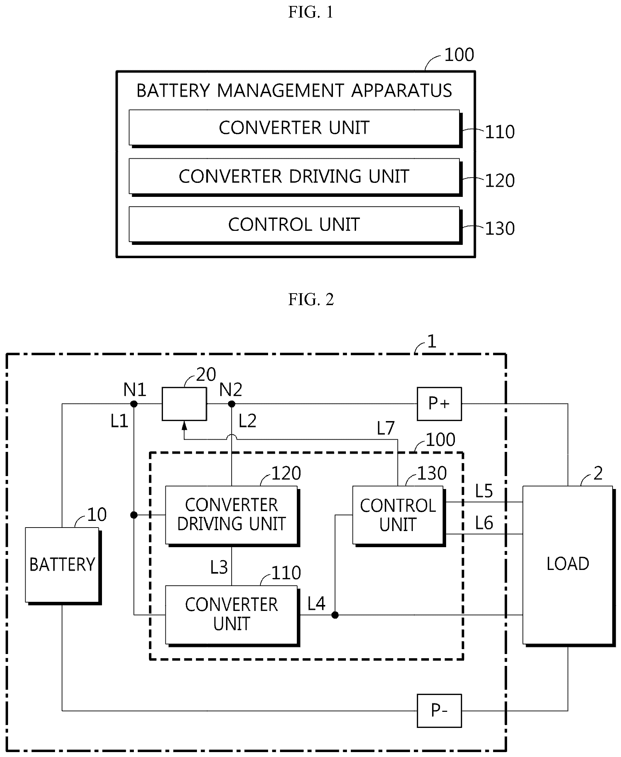

FIG. 1 is a diagram schematically showing a battery management apparatus 100 according to an embodiment of the present disclosure. FIG. 2 is a diagram schematically showing an exemplary configuration of a battery pack 1 including the battery management apparatus 100 according to an embodiment of the present disclosure.

Referring to FIG. 1, the battery management apparatus 100 may include a converter unit 110, a converter driving unit 120, and a control unit 130.

The converter unit 110 may be configured to be electrically connected to a first node N1 between a battery 10 and one end of a positive electrode relay 20 connected in series to the battery 10.

Here, the battery 10 means one physically separable independent cell including a negative electrode terminal and a positive electrode terminal. For example, a lithium-ion battery or a lithium polymer battery may be regarded as the battery 10. Also, the battery 10 may be a battery module in which a plurality of cells are connected in series and/or in parallel. Hereinafter, for convenience of explanation, the battery 10 will be described as meaning one independent cell.

For example, in the embodiment of FIG. 2, the battery 10 may be provided in the battery pack 1. In addition, a positive electrode terminal (+) of the battery 10 may be connected to a positive electrode terminal (P+) of the battery pack 1, and a negative electrode terminal (-) of the battery 10 may be connected to a negative electrode terminal (P-) of the battery pack 1.

In addition, a positive electrode relay 20 may be provided between the positive electrode terminal (+) of the battery 10 and the positive electrode terminal (P+) of the battery pack 1. That is, one end of the positive electrode relay 20 may be connected to the positive electrode terminal (+) of the battery 10, and the other end of the positive electrode relay 20 may be connected to the positive electrode terminal (P+) of the battery pack 1.

For example, in the embodiment of FIG. 2, the converter unit 110 may be electrically connected to the first node N1 between the positive electrode terminal (+) of the battery 10 and one end of the positive electrode relay 20, and receive a battery voltage through a first line L1 connected to the first node N1.

The converter unit 110 may be configured to convert the voltage of the battery 10 to a predetermined voltage and output the predetermined voltage based on the operation mode.

For example, the converter unit 110 may be a DC-DC converter that converts the voltage of the battery 10 into a predetermined voltage (e.g., 12 V) and outputs the converted voltage. In the embodiment of FIG. 2, the converter unit 110 may convert the battery voltage input through the first line L1 into a predetermined voltage, and output the converted voltage to the control unit 130 and a load 2 through a fourth line L4.

The converter driving unit 120 may be connected to the first node N1 and configured to receive the battery voltage from the battery 10.

For example, the converter driving unit 120 may be driven by receiving the battery voltage from the battery 10. That is, the converter driving unit 120 may be driven by receiving a power from the battery 10.

In the embodiment of FIG. 2, the converter unit 110 and the converter driving unit 120 may be connected to the first node N1, and receive the battery voltage through the first line L1. However, the converter unit 110 and the converter driving unit 120 are not connected to the first node N1 only through a common line (first line L1), but it should be noted that they may also be connected between the positive electrode terminal (+) of the battery 10 and one end of the positive electrode relay 20 through a separate line.

The converter driving unit 120 may be configured to control the operation mode of the converter unit 110 based on the battery voltage to a shutdown mode in which the converter unit 110 is inactivated or a wakeup mode in which the converter unit 110 is activated.

Specifically, the converter driving unit 120 may be configured to compare the battery voltage with a preset criterion voltage and control the operation mode of the converter unit 110 based on the comparison result.

Here, the criterion voltage is a preset voltage value and may be set to correspond to the voltage of an overdischarged battery 10. That is, if the battery voltage is less than the criterion voltage, the battery 10 is in a state that requires charging, and additional discharging of the battery 10 in this situation may cause degradation of the battery 10.

For example, the converter driving unit 120 may be configured to control the operation mode of the converter unit 110 to a shutdown mode or a wakeup mode according to the comparison result of the battery voltage and the criterion voltage.

Here, the converter unit 110 may include a terminal for receiving a battery voltage through the first line L 1 and a terminal for receiving a control signal from the converter driving unit 120 through the third line L3, respectively.

For example, in the embodiment of FIG. 2, the converter driving unit 120 may output a control signal, which is capable of controlling the operation mode of the converter unit 110 through the third line L3. The converter unit 110 may control the operation mode to a shutdown mode or a wakeup mode according to the control signal received from the converter driving unit 120 through the third line L3.

Here, the shutdown mode means a mode in which the converter unit 110 is inactivated not to receive the battery voltage through the first line L1. Conversely, the wakeup mode means a mode in which the converter unit 110 is activated to convert the battery voltage input through the first line L1 into a predetermined voltage and output the converted voltage through the fourth line L4. That is, the shutdown mode is a mode in which the state of the converter unit 110 is turned off, and the wakeup mode is a mode in which the state of the converter unit 110 is turned on.

As a specific example, when the battery voltage is less than the criterion voltage, the converter driving unit 120 may be configured to control the operation mode of the converter unit 110 to a shutdown mode. That is, when the battery voltage is less than the criterion voltage, the converter driving unit 120 may output a control signal for controlling the operation mode of the converter unit 110 to a shutdown mode through the third line L3. In this case, since the converter unit 110 cannot receive the battery voltage from the battery 10, it is possible to prevent the voltage of the battery 10 from being continuously consumed by the converter unit 110. Moreover, since the converter unit 110 is inactivated so that the voltage converted by the converter unit 110 is not output, components included in the battery pack 1 other than the converter driving unit 120 may also be inactivated.

Conversely, when the battery voltage is equal to or greater than the criterion voltage, the converter driving unit 120 may be configured to control the operation mode of the converter unit 110 to a wakeup mode. That is, when the battery voltage is equal to or greater than the criterion voltage, the converter driving unit 120 may output a control signal for controlling the operation mode of the converter unit 110 to a wakeup mode through the third line L3. In this case, the converter unit 110 may receive a battery voltage from the battery 10, convert the received battery voltage into a predetermined voltage, and output the converted voltage. Moreover, since the converter unit 110 is activated, other components included in the battery pack 1 may also be activated.

That is, the battery management apparatus 100 according to an embodiment of the present disclosure is characterized by inactivating the converter unit 110 when the battery voltage is less than the criterion voltage, in order to prevent the voltage of the battery 10 from being continuously reduced by the converter unit 110. Through this, since the occurrence of leakage current of the battery 10 may be minimized, it is possible to prevent the battery 10 from being overdischarged, and further to increase the lifespan of the battery 10.

The converter driving unit 120 may be configured to be further connected to a second node N2 at the other end side of the positive electrode relay 20.

For example, in the embodiment of FIG. 2, the converter driving unit 120 may be connected to the second node N2 between the other end of the positive electrode relay 20 and the positive electrode terminal (P+) of the battery pack 1 through a second line L2.

The converter driving unit 120 may be configured to control the operation mode of the converter unit 110 when an external voltage is input through the second node N2.

For example, if the battery pack 1 is connected to the load 2, an external voltage may be applied from the load 2 to the second node N2. The converter driving unit 120 may receive the external voltage applied from the load 2 through the second node N2.

Specifically, if the battery pack 1 is connected to a charging device, an external voltage may be applied from the charging device before charging of the battery 10 is started by the charging device. Here, the external voltage may be a signal requesting to start charging. That is, the converter driving unit 120 may control the operation mode of the converter unit 110 when receiving the external voltage that corresponds to a signal for requesting to start charging.

Also, while the battery 10 is being charged, since an external voltage is continuously applied by the charging device, the converter driving unit 120 may maintain the operation mode of the converter unit 110 as a wakeup mode.

More specifically, if the battery voltage is less than the criterion voltage, the operation mode of the converter unit 110 may be controlled to a shutdown mode. In addition, if the operation mode of the converter unit 110 is the shutdown mode, the voltage level of the battery 10 may be a level that requires charging. Accordingly, if the operation mode of the converter unit 110 is the shutdown mode, the converter driving unit 120 may be configured to control the operation mode of the converter unit 110 to a wakeup mode when an external voltage is received.

If the operation mode of the converter unit 110 is switched to the wakeup mode, the converter unit 110 may receive the battery voltage from the battery 10, convert the received battery voltage to a predetermined voltage, and output the converted voltage through the fourth line L4.

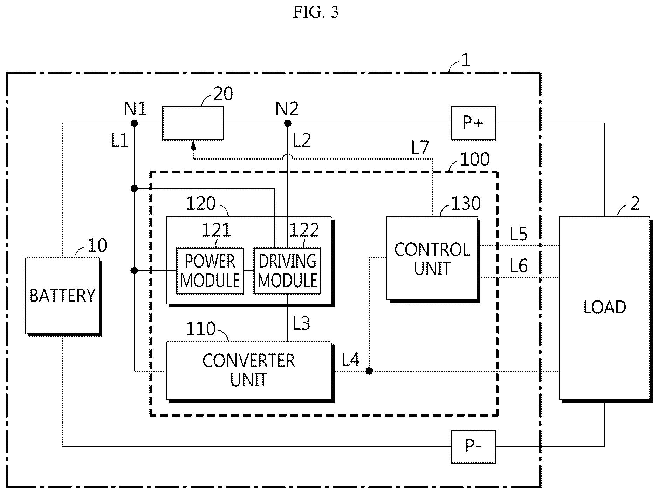

FIG. 3 is a diagram showing the battery pack 1 of FIG. 2 in more detail.

Referring to FIG. 3, the converter driving unit 120 may include a power module 121 and a driving module 122.

The power module 121 may be electrically connected to the first node N1 and be configured to receive the battery voltage from the battery 10, convert the received battery voltage and output the converted battery voltage.

For example, the power module 121 may be electrically connected to the first node N1 to receive the battery voltage, and convert the received battery voltage into a 5 V voltage. In addition, the power module 121 may output the converted 5 V voltage to the driving module 122.

For example, the power module 121 may adopt a low dropout (LDO), which is a linear regulator capable of converting the battery voltage to a low voltage.

The driving module 122 may be configured to receive a power from the power module 121. That is, since the driving module 122 does not receive a power through the converter unit 110 but receives a power through the power module 121, the driving module 122 may be always driven even if the operation mode of the converter unit 110 is controlled to a shutdown mode.

The driving module 122 is electrically connected to the first node N1, the second node N2 and the converter unit 110, and may be configured to control the operation mode of the converter unit 110 based on the battery voltage received through the first node N1, the external voltage received through the second node N2, and the criterion voltage.

For example, in the embodiment of FIG. 3, the driving module 122 may be connected to the first node N1 through the first line L1. The driving module 122 may receive the battery voltage through the first line L1, and control the operation mode of the converter unit 110 according to a result of comparing the battery voltage and the criterion voltage. The driving module 122 may output a signal for controlling the operation mode of the converter unit 110 to a shutdown mode or a wakeup mode through the third line L3.

Also, the driving module 122 may be connected to the second node N2 through the second line L2. After the operation mode of the converter unit 110 is controlled to a shutdown mode because the battery voltage is less than the criterion voltage, if the driving module 122 receives an external voltage through the second line L2, the driving module 122 may output a signal for controlling the operation mode of the converter unit 110 to a wakeup mode through the third line L3.

The battery management apparatus 100 according to an embodiment of the present disclosure including the converter driving unit 120 that receives a power directly from the battery 10 has an advantage of efficiently controlling the operation mode of the converter unit 110.

Referring to FIG. 1, the battery management apparatus 100 according to an embodiment of the present disclosure may further include a control unit 130.

The control unit 130 may be configured to control the operation state to an inactive mode or an active mode based on whether a power is applied according to the operation mode of the converter unit 110.

Specifically, when the operation mode of the converter unit 110 is controlled to a wakeup mode, the control unit 130 may receive a power from the converter unit 110 to control the operation state to an active mode. For example, in the embodiment of FIG. 2, the converter unit 110 and the control unit 130 may be connected through a fourth line L4. In addition, when the operation mode is a wakeup mode, the converter unit 110 may convert the battery voltage to a predetermined voltage, and output the converted voltage through the fourth line L4. Accordingly, when the operation mode of the converter unit 110 is a wakeup mode, the control unit 130 may receive the operation power from the converter unit 110 to control the operation state to an active mode.

Conversely, when the operation mode of the converter unit 110 is controlled to a shutdown mode, the control unit 130 may not receive a power from the converter unit 110 to control the operation state to an inactive mode. For example, the converter unit 110 may not receive the battery voltage when the operation mode is a shutdown mode. Accordingly, since the control unit 130 cannot receive the operation power from the converter unit 110, the operation state may be controlled to an inactive mode.

The control unit 130 may be configured to control the operation state of the positive electrode relay 20 according to the controlled operation state.

In the embodiment of FIG. 2, the control unit 130 may be connected to the positive electrode relay 20 through a seventh line L7, and may output a control signal to the positive electrode relay 20 through the seventh line L7.

For example, when the operation state is controlled from the active mode to the inactive mode, the control unit 130 may be configured to control the operation state of the positive electrode relay 20 to a turn-off state. That is, when the operation state of the control unit 130 is controlled to an inactive mode, the output of the control signal through the seventh line L7 may be stopped. Accordingly, when the operation state of the control unit 130 is controlled to an inactive mode, the operation state of the positive electrode relay 20 may be controlled to a turn-off state.

Conversely, the control unit 130 may be configured to control the operation state of the positive electrode relay 20 to a turn-on state, when the operation state is controlled from the inactive mode to the active mode.

For example, in the embodiment of FIG. 2, when the operation mode of the converter unit 110 is controlled to a wakeup mode, the converter unit 110 may output a voltage to the control unit 130 and the load 2 through the fourth line L4. Thereafter, the load 2 may output an enable signal to the control unit 130 through a fifth line L5, and the control unit 130 may communicate with the load 2 through the sixth line L6 when receiving the enable signal through the fifth line L5. In addition, the control unit 130 may control the operation state of the positive electrode relay 20 to a turn-on state through the seventh line L7, in a state capable of communicating with the load 2 through the sixth line L6.

Meanwhile, the control unit 130 provided in the battery management apparatus 100 may selectively include processors known in the art, application-specific integrated circuit (ASIC), other chipsets, logic circuits, registers, communication modems, data processing devices, and the like to execute various control logic performed in the present disclosure. Also, when the control logic is implemented in software, the control unit 130 may be implemented as a set of program modules. At this time, the program module may be stored in a memory and executed by the control unit 130. The memory may be located inside or out of the control unit 130 and may be connected to the control unit 130 by various well-known means.

In addition, the battery management apparatus 100 may further include a storage unit (not shown). The storage unit may store data necessary for operation and function of each component of the battery management apparatus 100, data generated in the process of performing the operation or function, or the like. The storage unit is not particularly limited in its kind as long as it is a known information storage means that can record, erase, update and read data. As an example, the information storage means may include RAM, flash memory, ROM, EEPROM, registers, and the like. In addition, the storage unit may store program codes in which processes executable by the control unit 130 are defined.

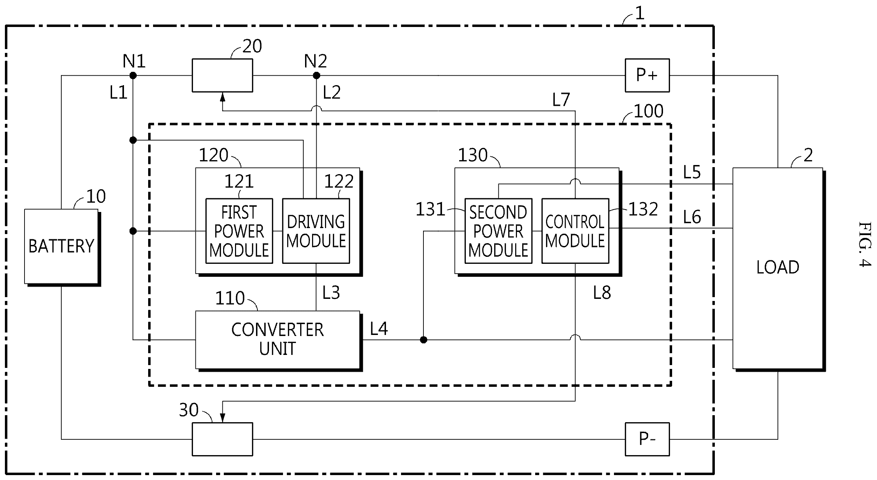

FIG. 4 is a diagram schematically showing another exemplary configuration of the battery pack 1 including the battery management apparatus 100 according to an embodiment of the present disclosure.

Referring to FIG. 4, the converter driving unit 120 may include a first power module 121 and a driving module 122, the control unit 130 may include a second power module 131 and a control module 132.

The second power module 131 may be connected to the converter unit 110 through the fourth line L4. In addition, when the operation mode of the converter unit 110 is a wakeup mode, the second power module 131 may receive the converted voltage from the converter unit 110 through the fourth line L4.

In addition, the second power module 131 may be connected to the load 2 through the fifth line L5. In addition, when receiving the enable signal from the load 2 through the fifth line L5, the second power module 131 may apply a power to the control module 132 to control the operation state of the control module 132 to an activated state.

When a power is received from the second power module 131, the control module 132 may be connected to communicate with the load 2 through the sixth line L6. When the control module 132 is able to communicate with the load 2 through the sixth line L6, the control module 132 may control the operation state of the positive electrode relay 20 through the seventh line L7.

Also, referring to FIG. 4, the battery pack 1 may further include a negative electrode relay 30 connected between the negative electrode terminal (-) of the battery 10 and the negative electrode terminal (P-) of the battery pack 1. That is, one end of the negative electrode relay 30 may be connected to the negative electrode terminal (-) of the battery 10, and the other end of the negative electrode relay 30 may be connected to the negative electrode terminal (P-) of the battery pack 1.

After the control module 132 is connected to be able to communicate with the load 2 through the sixth line L6, the control module 132 may control the operation state of the negative electrode relay 30 through an eighth line L8.

For example, in the embodiment of FIG. 4, when the control module 132 is in a state capable of communicating with the load 2 through the sixth line L6, the control module 132 may control the operation state of the positive electrode relay 20 to a turn-on state through the seventh line L7 and control the operation state of the negative electrode relay 30 to a turn-on state through the eighth line L8. Therefore, the positive electrode terminal (+) of the battery 10, the positive electrode terminal (P+) of the battery pack 1, the load 2, the negative electrode terminal (P-) of the battery pack 1, and the negative electrode terminal (-) of the battery 10 may be electrically connected, and the battery 10 may be charged by the load 2.

Also, referring to FIG. 4, the load 2 may be configured to be connected to the positive electrode terminal (P+) and the negative electrode terminal (P-) of the battery pack 1.

For example, in the embodiment of FIG. 4, one end of load 2 may be connected to the positive electrode terminal (P+) of the battery pack 1, the other end of the load 2 may be connected to the negative electrode terminal (P-) of the battery pack 1. In addition, when both the operation states of the positive electrode relay 20 and the negative electrode relay 30 are controlled to a turn-on state, the battery 10 and the load 2 may be electrically connected.

Meanwhile, the battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the configuration included in the conventional BMS. For example, the converter unit 110, the converter driving unit 120 and the control unit 130 may be implemented as components of the BMS.

The embodiments of the present disclosure described above may not be implemented only through an apparatus, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

In addition, since the present disclosure described above can be substituted, modified and changed in various ways by those skilled in the art without departing from the technical idea of the present disclosure, the present disclosure is not limited by the embodiments described above and the accompanying drawings, and all or some of the embodiments may be selectively combined to enable various modifications.

### (Reference Signs)

1: battery pack
2: load
10: battery
20: positive electrode relay
30: negative electrode relay
100: battery management apparatus
110: converter unit
120: converter driving unit
121: power module, first power module
122: driving module
130: control unit
131: second power module
132: control module

## Claims

1. A battery management apparatus, comprising:
a converter unit electrically connected to a first node between a battery and one end of a positive electrode relay connected in series to the battery and configured to convert a voltage of the battery into a predetermined voltage and output the predetermined voltage based on an operation mode; and
a converter driving unit connected to the first node to receive the battery voltage from the battery and configured to control the operation mode of the converter unit based on the battery voltage to a shutdown mode in which the converter unit is inactivated or a wakeup mode in which the converter unit is activated.

2. The battery management apparatus according to claim 1,
wherein the converter driving unit is configured to compare the battery voltage with a preset criterion voltage and control the operation mode of the converter unit based on the comparison result.

3. The battery management apparatus according to claim 2,
wherein the converter driving unit is configured to control the operation mode of the converter unit to the shutdown mode, when the battery voltage is less than the criterion voltage, and
wherein the converter driving unit is configured to control the operation mode of the converter unit to the wakeup mode, when the battery voltage is equal to or greater than the criterion voltage.

4. The battery management apparatus according to claim 2,
wherein the converter driving unit is further connected to a second node at the other end of the positive electrode relay and configured to control the operation mode of the converter unit when an external voltage is input through the second node.

5. The battery management apparatus according to claim 4,
wherein in the case where the operation mode of the converter unit is the shutdown mode, the converter driving unit is configured to control the operation mode of the converter unit to the wakeup mode when the external voltage is input.

6. The battery management apparatus according to claim 4,
wherein the converter driving unit includes:
a power module electrically connected to the first node and configured to receive the battery voltage from the battery, convert the received battery voltage and output the converted battery voltage; and
a driving module configured to receive a power applied from the power module, electrically connected to the first node, the second node and the converter unit, and configured to control the operation mode of the converter unit based on the battery voltage received through the first node, the external voltage received through the second node, and the criterion voltage.

7. The battery management apparatus according to claim 1, further comprising:
a control unit configured to control an operation state thereof to an inactive mode or an active mode based on whether a power is applied according to the operation mode of the converter unit and control an operation state of the positive electrode relay according to the controlled operation state.

8. The battery management apparatus according to claim 7,
wherein the control unit is configured to control the operation state to the active mode by receiving a power from the converter unit, when the operation mode of the converter unit is controlled to the wakeup mode, and
wherein the control unit is configured to control the operation state to the inactive mode by not receiving a power from the converter unit, when the operation mode of the converter unit is controlled to the shutdown mode.

9. The battery management apparatus according to claim 8,
wherein the control unit is configured to control the operation state of the positive electrode relay to a turn-off state, when the operation state is controlled from the active mode to the inactive mode, and
wherein the control unit is configured to control the operation state of the positive electrode relay to a turn-on state, when the operation state is controlled from the inactive mode to the active mode.

10. A battery pack, comprising the battery management apparatus according to any one of claims 1 to 9.
